# EUROPEAN PATENT APPLICATION

(11) **EP 4 757 502 A1**
(43) Date of publication of application: **10.06.2026**
(21) Application number: 25217486.7
(22) Date of filing: 20.11.2025
(51) Int. Cl.: H05K 1/02, H10W 40/47, H05K 1/11, H05K 1/185, H05K 3/46, H10W 40/20, H10W 40/22

(54) **CHIP-EMBEDDED CIRCUIT BOARD ASSEMBLY AND MANUFACTURING METHOD THEREFOR**

(30) Priority: 05.12.2024 CN 202411782801
(71) Applicant: ZF Friedrichshafen AG, 88046 Friedrichshafen (DE)
(72) Inventor: XU, Qing, Shanghai, 201615 (CN); YUAN, George, Shanghai, 201615 (CN)
(74) Representative: Nowack, Linda

(57) **Abstract**

The present disclosure relates to the technical field of circuit boards, and provides a chip-embedded circuit board assembly and a manufacturing method therefor. The chip-embedded circuit board assembly includes: a prefabricated circuit board; a chip packaging unit embedded in the prefabricated circuit board, where heat dissipation fins are provided on a back surface of the chip packaging unit, and the heat dissipation fins protrude outward from a lower surface of the prefabricated circuit board; and a dual-layer cooler provided below the prefabricated circuit board, the dual-layer cooler including an oil cooling cavity that is in contact with the heat dissipation fins and a water cooling cavity that is in contact with the oil cooling cavity, where interfaces of the oil cooling cavity and the water cooling cavity are exposed from the prefabricated circuit board. The heat dissipation fins are configured to improve heat dissipation performance, and the heat dissipation fins protrude outward such that the dual-layer cooler does not need to be in contact with the heat dissipation fins in an embedded manner, and it is ensured that the interfaces of the oil cooling cavity and the water cooling cavity are exposed, to facilitate piping connection. The oil cooling cavity is configured to cool the heat dissipation fins and achieve insulation protection, and the water cooling cavity is configured to cool the oil cooling cavity, thereby improving the heat conduction effect, and thus enhancing the cooling effect on the chip packaging unit and the prefabricated circuit board.

## Description

### Technical Field

The present disclosure relates to the technical field of circuit boards, and in particular to a chip-embedded circuit board assembly and a manufacturing method therefor.

### Background Art

A chip-embedded circuit board means embedding a chip unit in a circuit board to improve the integration level of the circuit board. As the integration level increases, the heat dissipation problem of the circuit board also becomes increasingly severe. Currently, methods such as attaching a thermal adhesive to heat-generating concentration areas of the circuit board are usually used for heat dissipation, but the heat dissipation effect is very limited and effective heat dissipation for a circuit board with a high integration level cannot be implemented.

It should be noted that information disclosed in the above background art section is only used to enhance the understanding of the background of the present disclosure, and therefore may include information that does not constitute the prior art known to those of ordinary skill in the art.

### Summary

The present disclosure provides a chip-embedded circuit board assembly and a manufacturing method therefor, which implements effective heat dissipation for the chip-embedded circuit board through outward-protruding heat dissipation fins cooperating with a dual-layer cooler.

According to one aspect of the present disclosure, a chip-embedded circuit board assembly is provided, the chip-embedded circuit board assembly including: a prefabricated circuit board; a chip packaging unit embedded in the prefabricated circuit board, where heat dissipation fins are provided on a back surface of the chip packaging unit, and the heat dissipation fins protrude outward from a lower surface of the prefabricated circuit board; and a dual-layer cooler provided below the prefabricated circuit board, the dual-layer cooler including an oil cooling cavity that is in contact with the heat dissipation fins and a water cooling cavity that is in contact with the oil cooling cavity, where interfaces of the oil cooling cavity and the water cooling cavity are exposed from the prefabricated circuit board.

In some embodiments, the dual-layer cooler includes a heat exchange frame and cover plates provided on opposite sides of the heat exchange frame and separately cooperating with the heat exchange frame to form the oil cooling cavity and the water cooling cavity, where a cover plate that is in contact with the back surface of the chip packaging unit and the lower surface of the prefabricated circuit board is an insulating cover plate.

In some embodiments, heat exchange fins are provided on surfaces of the heat exchange frame that face the oil cooling cavity and the water cooling cavity.

In some embodiments, the insulating cover plate is hermetically connected to the back surface of the chip packaging unit and the lower surface of the prefabricated circuit board.

In some embodiments, the prefabricated circuit board includes: a conductive layer; and a multi-layer dielectric layer stacked below the conductive layer, where the chip packaging unit is embedded in the conductive layer and the multi-layer dielectric layer, and the heat dissipation fins protrude outward from a lower surface of the multi-layer dielectric layer.

In some embodiments, the prefabricated circuit board includes: a first conductive layer; a dielectric layer provided below the first conductive layer; and a second conductive layer provided below the dielectric layer, where the chip packaging unit is embedded in the first conductive layer, the dielectric layer, and the second conductive layer, and the heat dissipation fins protrude outward from a lower surface of the second conductive layer.

In some embodiments, the chip-embedded circuit board assembly further includes: at least one dielectric film layer and at least one conductive film layer that are stacked above the prefabricated circuit board, where an electrode of the chip packaging unit is led out through the dielectric film layer and the conductive film layer to an upper surface of a top conductive film layer.

In some embodiments, two chip packaging units are embedded in the prefabricated circuit board, where each of the chip packaging units is connected to one dual-layer cooler, and oil cooling cavities of two dual-layer coolers communicate with each other and water cooling cavities of the two dual-layer coolers communicate with each other.

According to another aspect of the present disclosure, a manufacturing method for a chip-embedded circuit board assembly is provided, which is used for manufacturing and forming a chip-embedded circuit board assembly according to any one of the above embodiments, the manufacturing method including: providing a prefabricated circuit board; embedding a chip packaging unit in the prefabricated circuit board, where heat dissipation fins are provided on a back surface of the chip packaging unit, and the heat dissipation fins protrude outward from a lower surface of the prefabricated circuit board; and providing a dual-layer cooler below the prefabricated circuit board, so that an oil cooling cavity of the dual-layer cooler is in contact with the heat dissipation fins and a water cooling cavity of the dual-layer cooler is in contact with the oil cooling cavity, and interfaces of the oil cooling cavity and the water cooling cavity are exposed from the prefabricated circuit board.

In some embodiments, the manufacturing method further includes: stacking at least one dielectric film layer and at least one conductive film layer above the prefabricated circuit board, and leading out an electrode of the chip packaging unit through the dielectric film layer and the conductive film layer to an upper surface of a top conductive film layer.

Compared with the prior art, the present disclosure has at least the following beneficial effects.

By means of the heat dissipation fins provided on the back surface of the chip packaging unit, the heat dissipation area is increased, and the heat dissipation performance is improved; and the heat dissipation fins protrude outward from the lower surface of the prefabricated circuit board such that the dual-layer cooler does not need to be in contact with the heat dissipation fins in an embedded manner, and it is ensured that the interfaces of the oil cooling cavity and the water cooling cavity are exposed from the prefabricated circuit board after the dual-layer cooler is connected, to facilitate piping connection to implement circulation of a cooling medium and accelerate cooling. The dual-layer cooler includes the oil cooling cavity that is in contact with the heat dissipation fins and the water cooling cavity that is in contact with the oil cooling cavity, where cooling oil in the oil cooling cavity is used for cooling the heat dissipation fins and achieving insulation protection for the chip packaging unit, and cooling water in the water cooling cavity is used for cooling the cooling oil, improving the heat conduction effect of the cooling oil, and thus enhancing the cooling effect on the chip packaging unit and the prefabricated circuit board.

The chip-embedded circuit board assembly according to the present disclosure implements effective heat dissipation for the chip-embedded circuit board through the outward-protruding heat dissipation fins cooperating with the dual-layer cooler.

It should be understood that the above general description and the following detailed description are only exemplary and explanatory, and cannot limit the present disclosure.

### Brief Description of the Drawings

The accompanying drawings herein, which are incorporated into and constitute a part of the description, illustrate embodiments consistent with the present disclosure and, together with the description, are used to explain principles of the present disclosure. Obviously, the accompanying drawings described below show merely some of the embodiments of the present disclosure, and those of ordinary skill in the art would also have obtained other accompanying drawings according to these accompanying drawings without any creative effort.
FIG. 1 is a schematic structural diagram of a chip-embedded circuit board assembly according to an embodiment of the present disclosure;
FIG. 2 is a schematic structural diagram of another chip-embedded circuit board assembly according to an embodiment of the present disclosure;
FIG. 3 is a schematic structural diagram of another chip-embedded circuit board assembly according to an embodiment of the present disclosure;
FIG. 4 is a schematic diagram of steps of a manufacturing method for a chip-embedded circuit board assembly according to an embodiment of the present disclosure; and
FIG. 5 is a schematic diagram of steps of another manufacturing method for a chip-embedded circuit board assembly according to an embodiment of the present disclosure.

### Detailed Description of Embodiments

Now exemplary implementations will be described more fully with reference to the accompanying drawings. However, the exemplary implementations can be implemented in many forms and should not be construed as being limited to the implementations described herein. On the contrary, these implementations are provided to make the present disclosure more thorough and complete, and to fully convey the concept of the exemplary implementations to those skilled in the art.

The accompanying drawings are only schematic illustrations of the present disclosure, and are not necessarily drawn to scale. In the accompanying drawings, the same reference numerals denote the same or similar parts, and thus the repeated description thereof will be omitted.

The processes shown in the accompanying drawings are only exemplary illustrations, and do not necessarily include all steps. For example, some steps can be divided, and some steps can be combined or partially combined, and the actual execution order thereof may be changed based on actual conditions. The terms "first", "second" and similar terms used in the specific description do not denote any order, quantity, or importance, but are merely used to distinguish between different components. Orientations or positional relationships indicated by the terms such as "upper" and "lower" are based on orientations or positional relationships shown in the accompanying drawings, which is only for convenience of describing the present disclosure and simplifying the description, rather than indicating or implying that an apparatus or an element referred to must have a specific orientation or be constructed and operated in a specific orientation, and therefore cannot be construed as limiting the present disclosure. Moreover, in the description of the present disclosure, when it is said that a device is "connected" to another device, this includes not only the case of direct connection but also the case of indirect connection through other elements.

It should be noted that the embodiments in the present disclosure and features of the various embodiments can be combined with each other without conflict.

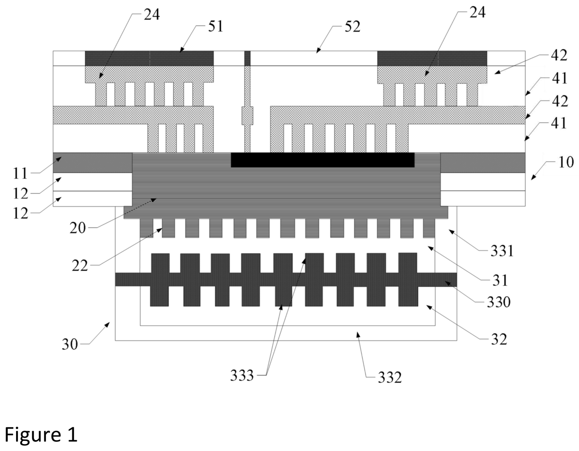

FIG. 1 illustrates a structure of a chip-embedded circuit board assembly. Referring to FIG. 1, the chip-embedded circuit board assembly according to an embodiment of the present disclosure includes:
a prefabricated circuit board 10;
a chip packaging unit 20, embedded in the prefabricated circuit board 10, where heat dissipation fins 22 are provided on a back surface of the chip packaging unit 20, and the heat dissipation fins 22 protrude outward from a lower surface of the prefabricated circuit board 10; and
a dual-layer cooler 30 provided below the prefabricated circuit board 10, the dual-layer cooler 30 including an oil cooling cavity 31 that is in contact with the heat dissipation fins 22 and a water cooling cavity 32 that is in contact with the oil cooling cavity 31, where interfaces of the oil cooling cavity 31 and the water cooling cavity 32 are exposed from the prefabricated circuit board 10.

By means of the heat dissipation fins 22 provided on the back surface of the chip packaging unit 20, the heat dissipation area is increased, and the heat dissipation performance is improved; and the heat dissipation fins 22 protrude outward from the lower surface of the prefabricated circuit board 10 such that the dual-layer cooler 30 does not need to be in contact with the heat dissipation fins 22 in an embedded manner, and it is ensured that the interfaces of the oil cooling cavity 31 and the water cooling cavity 32 of the dual-layer cooler 30 are exposed from the prefabricated circuit board 10, to facilitate piping connection to implement circulation of a cooling medium and accelerate cooling. The dual-layer cooler 30 includes the oil cooling cavity 31 that is in contact with the heat dissipation fins 22 and the water cooling cavity 32 that is in contact with the oil cooling cavity 31, where cooling oil in the oil cooling cavity 31 is used for cooling the heat dissipation fins 22 and achieving insulation protection for the chip packaging unit 20, and cooling water in the water cooling cavity 32 is used for cooling the cooling oil, improving the heat conduction effect of the cooling oil, and thus enhancing the cooling effect on the chip packaging unit 20 and the prefabricated circuit board 10.

Thus, the chip-embedded circuit board assembly according to the present disclosure implements effective heat dissipation for the chip-embedded circuit board through the outward-protruding heat dissipation fins 22 cooperating with the dual-layer cooler 30.

In some embodiments, the dual-layer cooler 30 includes a heat exchange frame 330 and cover plates 331 and 332 provided on opposite sides of the heat exchange frame 330 and separately cooperating with the heat exchange frame 330 to form the oil cooling cavity 31 and the water cooling cavity 32, where the cover plate 331 that is in contact with the back surface of the chip packaging unit 20 and the lower surface of the prefabricated circuit board 10 is an insulating cover plate.

By means of the heat exchange frame 330, heat exchange between the oil cooling cavity 31 and the water cooling cavity 32 is implemented, so as to use the cooling water in the water cooling cavity 32 to take away the heat of the cooling oil in the oil cooling cavity 31 through the heat exchange frame 330, thereby enhancing the cooling effect of the cooling oil on the chip packaging unit 20. The cover plate 331 that is in contact with the back surface of the chip packaging unit 20 is an insulating cover plate, to achieve insulation protection for the chip packaging unit 20.

The heat exchange frame 330 is, for example, an aluminum alloy frame, the cover plate 331 that is in contact with the back surface of the chip packaging unit 20 and the lower surface of the prefabricated circuit board 10 is, for example, a plastic cover plate, and the cover plate 332 configured to form the water cooling cavity 32 is, for example, a plastic or metal cover plate, which is not limited thereto.

In some embodiments, heat exchange fins 333 are provided on surfaces of the heat exchange frame 330 that face the oil cooling cavity 31 and the water cooling cavity 32. By means of the heat exchange fins 333, the contact area between the cooling oil and the cooling water is increased, the heat exchange efficiency between the oil cooling cavity 31 and the water cooling cavity 32 is improved, and thus the cooling effect of the dual-layer cooler 30 on the chip packaging unit 20 and the prefabricated circuit board 10 is enhanced.

In some embodiments, the insulating cover plate is hermetically connected to the back surface of the chip packaging unit 20 and the lower surface of the prefabricated circuit board 10. The insulating cover plate may specifically be hermetically connected to the back surface of the chip packaging unit 20 and the lower surface of the prefabricated circuit board 10 by gluing, welding, or other methods.

In some embodiments, the prefabricated circuit board 10 includes: a conductive layer 11; and a multi-layer dielectric layer 12 stacked below the conductive layer 11, where the chip packaging unit 20 is embedded in the conductive layer 11 and the multi-layer dielectric layer 12, and the heat dissipation fins 22 protrude outward from a lower surface of the multi-layer dielectric layer 12.

The conductive layer 11 is provided on an upper surface of the prefabricated circuit board 10, so as to implement electrical connection to the chip packaging unit 20; and the dielectric layer 12 is configured to support and implement insulation.

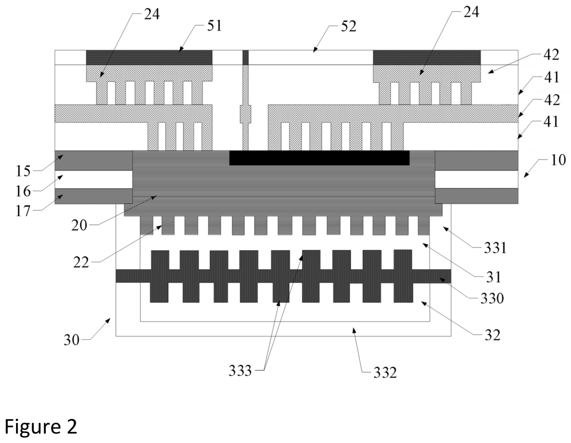

FIG. 2 illustrates a structure of another chip-embedded circuit board assembly. Referring to FIG. 2 and in combination with FIG. 1, in some embodiments, the prefabricated circuit board 10 includes: a first conductive layer 15; a dielectric layer 16 provided below the first conductive layer 15; and a second conductive layer 17 provided below the dielectric layer 16, where the chip packaging unit 20 is embedded in the first conductive layer 15, the dielectric layer 16, and the second conductive layer 17, and the heat dissipation fins 22 protrude outward from a lower surface of the second conductive layer 17.

Compared with the embodiment shown in FIG. 1, a lower surface of the prefabricated circuit board 10 in this embodiment is provided with a second conductive layer 17, which can enhance the electrical performance of the prefabricated circuit board 10. The same reference numerals in FIG. 2 and FIG. 1 represent the same components, and therefore the repeated description thereof will be omitted.

Further, with reference to FIG. 1 and FIG. 2, in some embodiments, the chip-embedded circuit board assembly further includes: at least one dielectric film layer 41 and at least one conductive film layer 42 that are stacked above the prefabricated circuit board 10, where an electrode of the chip packaging unit 20 is led out through the dielectric film layer 41 and the conductive film layer 42 to an upper surface of a top conductive film layer.

Above electrode lead-out wires 24 of the chip packaging unit 20, a pad 51 may further be provided to be connected to other electronic components, and an insulating protective layer 52 may be provided to implement protection of the chip-embedded circuit board, such as insulation, anti-corrosion, etc.

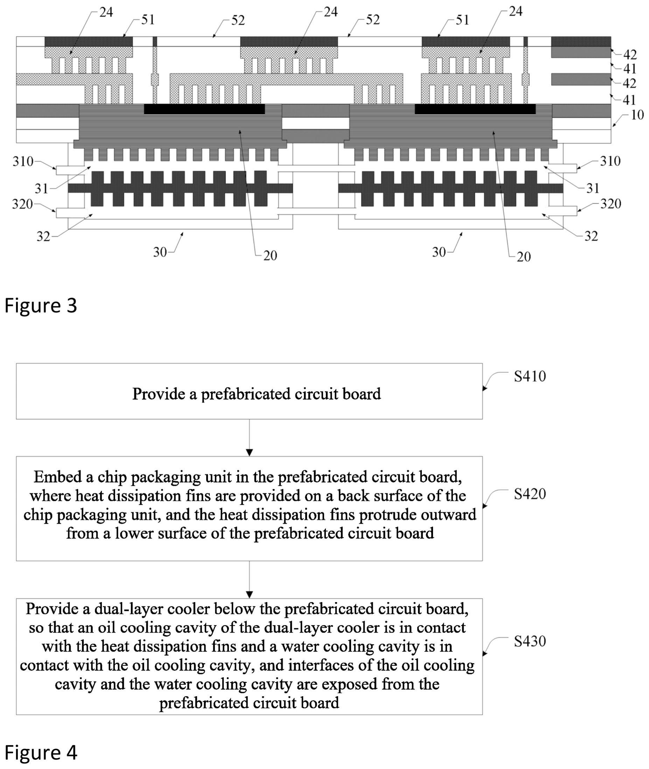

FIG. 3 illustrates a structure of another chip-embedded circuit board assembly. Referring to FIG. 3 and in combination with FIG. 1, in some embodiments, two chip packaging units 20 are embedded in the prefabricated circuit board 10, where each of the chip packaging units 20 is connected to one dual-layer cooler 30, and oil cooling cavities 31 of two dual-layer coolers 30 communicate with each other and water cooling cavities 32 of the two dual-layer coolers communicate with each other.

Thus, the two dual-layer coolers 30 only need to be provided with one pair of oil cooling interfaces 310 and one pair of water cooling interfaces 320, which can simplify piping connection and simplify the configuration of the chip-embedded circuit board assembly.

The same reference numerals in FIG. 3 and FIG. 1 represent the same components, and therefore the repeated description thereof will be omitted.

The chip-embedded circuit board assembly shown in FIG. 3 may be used as a half-bridge power module of an inverter. Efficient cooling of the chip packaging unit 20 is achieved through dual circulation of a cooling medium of the dual-layer cooler 30. In addition, the outward-protruding heat dissipation fins 22 are used, to increase the heat dissipation area and facilitate the piping connection of the dual-layer cooler 30. In this way, efficient and convenient cooling for the chip-embedded circuit board is implemented, and the circuit board adapts to high-power operating conditions of the inverter.

Embodiments of the present disclosure further provide a manufacturing method for a chip-embedded circuit board assembly, which is used for manufacturing and forming a chip-embedded circuit board assembly described in any one of the above embodiments. The features and principles of the chip-embedded circuit board assembly described in any of the above embodiments may be applied to the following embodiments of the manufacturing method. In the following embodiments of the manufacturing method, the features and principles of the chip-embedded circuit board assembly that have been described will not be repeated.

FIG. 4 illustrates main steps of a manufacturing method for a chip-embedded circuit board assembly. Referring to FIG. 4 and in combination with FIG. 1 to FIG. 3, the manufacturing method for a chip-embedded circuit board assembly according to an embodiment of the present disclosure includes the following steps:
S410: Provide a prefabricated circuit board 10.
S420: Embed a chip packaging unit 20 in the prefabricated circuit board 10, where heat dissipation fins 22 are provided on a back surface of the chip packaging unit 20, and the heat dissipation fins 22 protrude outward from a lower surface of the prefabricated circuit board 10.
S430: Provide a dual-layer cooler 30 below the prefabricated circuit board 10, so that an oil cooling cavity 31 of the dual-layer cooler 30 is in contact with the heat dissipation fins 22 and a water cooling cavity 32 is in contact with the oil cooling cavity 31, and interfaces of the oil cooling cavity 31 and the water cooling cavity 32 are exposed from the prefabricated circuit board 10.

By means of the heat dissipation fins 22 provided on the back surface of the chip packaging unit 20, the heat dissipation area is increased, and the heat dissipation performance is improved; and the heat dissipation fins 22 protrude outward from the lower surface of the prefabricated circuit board 10, the dual-layer cooler 30 does not need to be embedded, and it is ensured that the interfaces of the oil cooling cavity 31 and the water cooling cavity 32 are exposed from the prefabricated circuit board 10, to facilitate piping connection to implement circulation of a cooling medium and accelerate cooling. The dual-layer cooler 30 includes the oil cooling cavity 31 that is in contact with the heat dissipation fins 22 and the water cooling cavity 32 that is in contact with the oil cooling cavity 31, where cooling oil in the oil cooling cavity 31 is used for cooling the heat dissipation fins 22 and achieving insulation protection for the chip packaging unit 20, and cooling water in the water cooling cavity 32 is used for cooling the cooling oil, improving the heat conduction effect of the cooling oil, and thus enhancing the cooling effect on the chip packaging unit 20 and the prefabricated circuit board 10. Thus, the chip-embedded circuit board assembly manufactured and formed implements effective heat dissipation for the chip-embedded circuit board through the outward-protruding heat dissipation fins 22 cooperating with the dual-layer cooler 30.

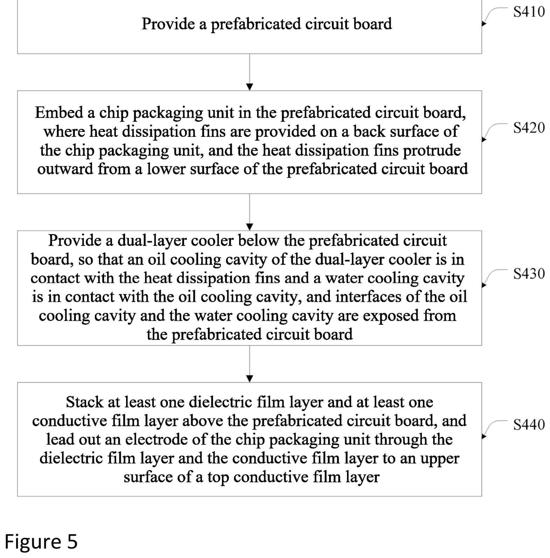

FIG. 5 illustrates another manufacturing method for a chip-embedded circuit board assembly. Compared with the embodiment shown in FIG. 4, the manufacturing method in this embodiment further includes the following step:
S440: Stack at least one dielectric film layer 41 and at least one conductive film layer 42 above the prefabricated circuit board 10, and lead out an electrode of the chip packaging unit 20 through the dielectric film layer 41 and the conductive film layer 42 to an upper surface of a top conductive film layer.

After electrode lead-out wires 24 of the chip packaging unit 20 are formed, a pad 51 and an insulating protective layer 52 may further be provided above the electrode lead-out wires.

The execution sequence of step S430 and step S440 may be reversed according to actual needs. If step S440 is executed first, the prefabricated circuit board 10 may be placed on a shim plate, so that the lower surface of the prefabricated circuit board 10 is fitted with the shim plate and the heat dissipation fins 22 are accommodated in an accommodating groove of the shim plate, thus protecting the heat dissipation fins 22 and preventing the fins from being crushed.

The above is a further detailed description of the present disclosure with reference to the specific preferred implementations, and it cannot be considered that the specific implementation of the present disclosure is limited to these descriptions. For those of ordinary skill in the art of the present disclosure, several simple deductions or substitutions can be further made without departing from the concept of the present disclosure, and should be regarded as falling within the scope of protection of the present disclosure.

## Claims

1. A chip-embedded circuit board assembly, comprising:
a prefabricated circuit board;
a chip packaging unit embedded in the prefabricated circuit board, wherein heat dissipation fins are provided on a back surface of the chip packaging unit, and the heat dissipation fins protrude outward from a lower surface of the prefabricated circuit board; and
a dual-layer cooler provided below the prefabricated circuit board, the dual-layer cooler comprising an oil cooling cavity that is in contact with the heat dissipation fins and a water cooling cavity that is in contact with the oil cooling cavity, wherein interfaces of the oil cooling cavity and the water cooling cavity are exposed from the prefabricated circuit board.

2. The chip-embedded circuit board assembly according to claim 1, wherein the dual-layer cooler comprises a heat exchange frame and cover plates provided on opposite sides of the heat exchange frame and separately cooperating with the heat exchange frame to form the oil cooling cavity and the water cooling cavity,
wherein a cover plate that is in contact with the back surface of the chip packaging unit and the lower surface of the prefabricated circuit board is an insulating cover plate.

3. The chip-embedded circuit board assembly according to claim 2, wherein heat exchange fins are provided on surfaces of the heat exchange frame that face the oil cooling cavity and the water cooling cavity.

4. The chip-embedded circuit board assembly according to claim 2, wherein the insulating cover plate is hermetically connected to the back surface of the chip packaging unit and the lower surface of the prefabricated circuit board.

5. The chip-embedded circuit board assembly according to claim 1, wherein the prefabricated circuit board comprises:
a conductive layer; and
a multi-layer dielectric layer stacked below the conductive layer, wherein the chip packaging unit is embedded in the conductive layer and the multi-layer dielectric layer, and the heat dissipation fins protrude outward from a lower surface of the multi-layer dielectric layer.

6. The chip-embedded circuit board assembly according to claim 1, wherein the prefabricated circuit board comprises:
a first conductive layer;
a dielectric layer provided below the first conductive layer; and
a second conductive layer provided below the dielectric layer, wherein the chip packaging unit is embedded in the first conductive layer, the dielectric layer, and the second conductive layer,
and the heat dissipation fins protrude outward from a lower surface of the second conductive layer.

7. The chip-embedded circuit board assembly according to claim 1, further comprising:
at least one dielectric film layer and at least one conductive film layer that are stacked above the prefabricated circuit board, wherein an electrode of the chip packaging unit is led out through the dielectric film layer and the conductive film layer to an upper surface of a top conductive film layer.

8. The chip-embedded circuit board assembly according to any one of claims 1 to 7, wherein two chip packaging units are embedded in the prefabricated circuit board, wherein each of the chip packaging units is connected to one dual-layer cooler, and oil cooling cavities of two dual-layer coolers communicate with each other and water cooling cavities of the two dual-layer coolers communicate with each other.

9. A manufacturing method for a chip-embedded circuit board assembly, which is used for manufacturing and forming a chip-embedded circuit board assembly according to any one of claims 1 to 8, the manufacturing method comprising:
providing a prefabricated circuit board;
embedding a chip packaging unit in the prefabricated circuit board, wherein heat dissipation fins are provided on a back surface of the chip packaging unit, and the heat dissipation fins protrude outward from a lower surface of the prefabricated circuit board; and
providing a dual-layer cooler below the prefabricated circuit board, so that an oil cooling cavity of the dual-layer cooler is in contact with the heat dissipation fins and a water cooling cavity of the dual-layer cooler is in contact with the oil cooling cavity, and interfaces of the oil cooling cavity and the water cooling cavity are exposed from the prefabricated circuit board.

10. The manufacturing method according to claim 9, further comprising:
stacking at least one dielectric film layer and at least one conductive film layer above the prefabricated circuit board, and leading out an electrode of the chip packaging unit through the dielectric film layer and the conductive film layer to an upper surface of a top conductive film layer.
